# EUROPEAN PATENT APPLICATION

(11) **EP 0 827 817 A1**
(43) Date of publication of application: **11.03.1998**
(21) Application number: 96850146.0
(22) Date of filing: 06.09.1996
(51) Int. Cl.: B27B 17/08, F16H 55/06, C23C 16/30

(54) **Coated chain saw nose sprocket**

(71) Applicant: SANDVIK AKTIEBOLAG, 811 81 Sandviken (SE)
(72) Inventor: Leini, Arvo, 828 00 Edsbyn (SE)

(57) **Abstract**

Nose sprocket for chain saws, comprising a body of substantially uniform thickness, towards the center limited by a bearing race (13) and at the periphery provided with teeth (11) to carry a saw chain, characterized by having a solid low-friction coating deposited from gas phase except on the bearing race (13) and the inner parts (15) of the sprocket body surfaces adjoining the bearing race, said coating comprising multiple sub-layers of graphite and tungsten carbide.

The coating having a total inclusive thickness of 1 micron or more on each side.

Method for producing a low-friction coating on selected parts of the surface of a nose sprocket for chain saws, characterized by the coating being deposited from gas phase, and by masking a central limiting surface (13) which is to be used as a bearing race as well as the adjoining inner parts (15) of the side surfaces during deposition.

## Description

### Background

Thin nose sprockets have long been used to carry a saw chain around the nose of a guide bar. The sprockets carry the chain without friction against the guide bar edges, resulting in less wear and less power requirement.

In vehicle-mounted chain saws the chain is subjected to very high velocity and tensile force. The engine power is much higher than in manual chain saws and the operator has no direct view of the cutting area. If a tree trunk is leaning when sawn through the saw chain and guide bar may be compressed so hard that the chain stops on a manual chain saw, but may still keep running on vehicle-mounted saw. This will cause damage by overheating the nose sprocket until it becomes buckled and skewed, followed by local welding and seizure. Several guide bar and sprocket designs have been suggested to lessen the risk of damage, such as increasing the space between the sprocket and the guide bar side plates, or pressure lubrication of the sprocket bearing with an excess of lubricant enough to lubricate the sprocket sides. This has at least created a possibility to continue sawing with a slightly deformed sprocket, but has not solved the problem of overheating during the initial compression stage.

The present invention is a nose sprocket, with a surface treatment to reduce overheating and to distribute the heat in such a way that the buckling risk is minimal.

### Description

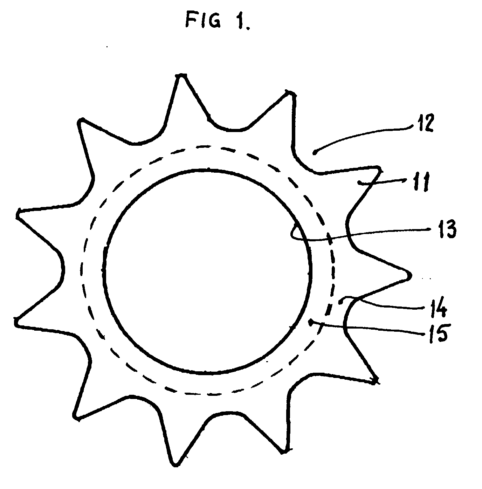

A nose sprocket according to the invention is shown in figure 1. The sprocket has at its periphery teeth (11) separated by gullets (12). The sprocket center is made as a roller bearing, where the outer race (13) is the inner edge of the sprocket.

Between the teeth and the outer race is the sprocket body. the sprocket is made from a metal plate with substantially equal thickness. The teeth (11) and the radially outer parts (14) of the sprocket body are coated with a surface layer of low friction material, while the bearing race (13) and the radially inner parts (15) of the sprocket body are left without such coating.

Several types of suitable coating material are known, including grapfite, molybdenium sulphide and composites with these materials. One such coating with suitable properties is commersially available under the name of Balinit C, and comprises a multitude of thin sub-layers of alternatingly tungsten carbide and graphite, each sub-layer up to 0.1 micron thich the total inclusive thickness up to 5 microns. This type of layer har great wear resistance as well as low friction, but is not suitable for point loads such as occur in roller bearings, and the bearing race (13) must thus be excluded from coating by being masked when the coating is deposited.

The inner parts (15) of the sprocket body should also be excluded from coating for two reasons. First, any risk of coating flakes entering the bearing must be eliminated. Second, the thickness of the sprocket should be kept slightly less at the inner parts (15) than at the outer parts (14) to ensure that there is less friction at the inner parts. Since the heat produced by friction will be dissipated through the teeth, an even heat production would cause the inner parts (15) to be much warmer than the outer parts (14), greatly increasing the risk of heat buckling of the sprocket to a conical shape, which in turn would make the temperature even less uniform. To counteract this, the coating of the outer parts (14) should be at least 1 micron thick on each side.

When the coating is deposited from vapour phase (CVD or PVD), masking of the surfaces which should be left uncoated is preferably done with specially shaped washers, or if a multitude of sprockets is to be coated simultaneously, by supporting a stack of sprockets and washers on a central shaft.

There is no sliding contact between the flanks of the teeth and the saw chain drive links and thus no need of coating, but to simplify masking, the flanks may be coated. This could also reduce wear of the chain.

## Claims

1. Nose sprocket for chain saws, comprising a body of substantially uniform thickness, towards the center limited by a bearing race (13) and at the periphery provided with teeth (11) to carry a saw chain , characterized by having a solid low-friction coating deposited from gas phase except on the bearing race (13) and the inner parts (15) of the sprocket body surfaces adjoining the bearing race, said coating comprising multiple sub-layers of graphite and tungsten carbide.

2. Nose sprocket according to claim 1, characterized by the coating having a total inclusive thickness of 1 micron or more on each side.

3. Method for producing a low-friction coating on selected parts of the surface of a nose sprocket for chain saws, characterized by the coating being deposited from gas phase, and by masking a central limiting surface (13) which is to be used as a bearing race as well as the adjoining inner parts (15) of the side surfaces during deposition.
